(19) **Europäisches Patentamt / European Patent Office / Office européen des brevets**

(11) **EP 2 955 166 A1**

(12) **EUROPEAN PATENT APPLICATION**
published in accordance with Art. 153(4) EPC

(43) Date of publication:
**16.12.2015 Bulletin 2015/51**

(21) Application number: **14749006.4**

(22) Date of filing: **05.02.2014**

(51) Int Cl.:
**C04B 35/00** [(2006.01)]    **C04B 35/622** [(2006.01)]
**H01L 41/187** [(2006.01)]    **H01L 41/22** [(2013.01)]

(86) International application number:
**PCT/JP2014/052623**

(87) International publication number:
**WO 2014/123134 (14.08.2014 Gazette 2014/33)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **06.02.2013  JP 2013021100**

(71) Applicant: **Murata Manufacturing Co., Ltd. Nagaokakyo-shi, Kyoto 617-8555 (JP)**

(72) Inventors:
• **MIWA, Yasunari**
  **Nagaokakyo-shi**
  **Kyoto 617-8555 (JP)**
• **KAWADA, Shinichiro**
  **Nagaokakyo-shi**
  **Kyoto 617-8555 (JP)**
• **KIMURA, Masahiko**
  **Nagaokakyo-shi**
  **Kyoto 617-8555 (JP)**

(74) Representative: **Reeve, Nicholas Edward**
  **Reddie & Grose LLP**
  **16 Theobalds Road**
  **London WC1X 8PL (GB)**

(54) **PIEZOELECTRIC ORIENTED CERAMIC AND METHOD FOR MANUFACTURING SAME**

(57)    There are provided a grain-oriented piezoelectric ceramic that is based on a potassium niobate compound containing at least Li and Na and can be produced using a known process for producing piezoelectric ceramics and can be oriented with a high degree of orientation in any intended direction and a method for producing this grain-oriented piezoelectric ceramic.

The grain-oriented piezoelectric ceramic according to this invention has a perovskite structure based on a potassium niobate compound containing at least Li and Na. The aspect ratio of the ceramic particles constituting this grain-oriented piezoelectric ceramic is 5 or less. The grain-oriented piezoelectric ceramic has an axis oriented in the {100} direction of the perovskite structure. The degree of orientation as determined using the Lotgering method on the basis of an X-ray diffraction pattern of a cross-section taken in this direction is 0.30 or more.

EP 2 955 166 A1

**Description**

Technical Field

This invention relates to an (Li, Na, K)NbO$_3$-based grain-oriented piezoelectric ceramic and a method for producing it.

Background Art

Perovskite-structured grain-oriented piezoelectric ceramics have been used as dielectric materials and piezoelectric materials. It is known that making the grains in these perovskite-structured grain-oriented piezoelectric further oriented improves their electrical characteristics.

An example of a proposed method for producing a perovskite-structured grain-oriented piezoelectric ceramic based on an alkaline niobate compound ((K, Na)NbO$_3$) is a technology described in Patent Document 1. The technology described in Patent Document 1 is a method for producing a grain-oriented piezoelectric ceramic, the method including a mixing step that involves mixing a first anisotropically shaped powder in lattice matching with a particular grain face of a first perovskite alkaline pentavalent metal acid compound and a first reactant that reacts with the first anisotropically shaped powder to form the first perovskite alkaline pentavalent metal acid compound, a shaping step that involves shaping the mixture obtained in the mixing step to make the first anisotropically shaped powder oriented, and a heat treatment step that involves heating the shaped article obtained in the shaping step to bring the first anisotropically shaped powder and the first reactant into reaction.

In other words, the method described in Patent Document 1 for producing a grain-oriented piezoelectric ceramic is a production method that yields a (K, Na)NbO$_3$-based grain-oriented piezoelectric ceramic oriented through a RTGG (Reactive Templated Grain Growth) method using NaNbO$_3$, a platelike powder, as template particles and a non-platelike NN (NaNbO$_3$) powder as raw materials and a non-platelike KN (KNbO$_3$) powder as raw materials for calcination.

Citation List

Patent Literature

Patent Document 1: Japanese Unexamined Patent Application Publication No. 2003-012373

Summary of Invention

Technical Problem

The method described in Patent Document 1 for producing a grain-oriented piezoelectric ceramic is, however, a technology that requires anisotropically shaped particles as template particles. Preparing these template particles requires a heat treatment in flux, which poses problems such as flux component residue in the anisotropically shaped particles, flux-induced damage to the heat treatment furnace, and the need for processing of removed flux. The preparation of the platelike powder as template particles, furthermore, involves the use of a strong acid after elemental substitution of the platelike powder to remove the Bi compound resulting from the substitution, which poses the problem of many production difficulties and great burdens on operators and the environment. A disadvantage of the method described in Patent Document 1 for producing a grain-oriented piezoelectric ceramic is therefore high cost due to a complicated production process. This method, in which orientation is through arrangement of anisotropically shaped particles during a sheet-shaping-based shaping step, is also disadvantageous in that the direction of orientation is limited. Furthermore, the resulting ceramics, composed of block-shaped particles laid up like bricks, are likely to have cracks.

The primary object of this invention is therefore to provide a grain-oriented piezoelectric ceramic that has a perovskite structure based on a potassium niobate compound containing at least Li and Na and can be produced using a known process for producing piezoelectric ceramics and can be oriented with a high degree of orientation in any intended direction, as well as a method for producing this grain-oriented piezoelectric ceramic.

Solution to Problem

A grain-oriented piezoelectric ceramic according to this invention has a perovskite structure based on a potassium niobate compound containing at least Li and Na. The aspect ratio of the ceramic particles constituting the grain-oriented piezoelectric ceramic is 5 or less. The grain-oriented piezoelectric ceramic has an axis oriented in the {100} direction of the perovskite structure. The degree of orientation as determined using the Lotgering method on the basis of an X-ray diffraction pattern of a cross-section taken in this direction is 0.30 or more.

It is preferred that the grain-oriented piezoelectric ceramic according to this invention having a perovskite structure take a tetragonal phase as its most stable or metastable grain structure at a temperature in a temperature range of 0°C to 100°C.

Furthermore, it is preferred that the average particle diameter of the ceramic particles in the grain-oriented piezoelectric ceramic according to this invention be in a range of 0.3 $\mu$m to 2.2 $\mu$m.

A method according to this invention for producing a grain-oriented piezoelectric ceramic is for producing a perovskite-structured grain-oriented piezoelectric ceramic whose degree of orientation as determined using the Lotgering method on the basis of an X-ray diffraction pattern of its predetermined cross-section is 0.30 or more. The method includes a step of preparing elementary raw material-mixed slurry containing an elementary raw material that is a perovskite compound based on a potassium niobate compound that contains at least Li and Na, a step of calcining a dried form of the elementary raw material-mixed slurry to prepare a calcined powder that takes a tetragonal phase as its most stable or metastable grain structure at a temperature in a temperature range of 0°C to 100°C, a step of preparing calcined powder slurry that contains the calcined powder, a step of shaping the calcined powder slurry into a sheet, and a step of applying a magnetic field to the sheet shaped from the calcined powder slurry.

In the method according to this invention for producing a grain-oriented piezoelectric ceramic, it is preferred that the step of preparing calcined powder slurry includes adding emulsified acrylic resin as a binder.

A grain-oriented piezoelectric ceramic according to this invention, having a perovskite structure based on a potassium niobate compound containing at least Li and Na, is highly oriented as demonstrated by a degree of orientation of 0.30 or more determined using the Lotgering method. The aspect ratio of the ceramic particles constituting this grain-oriented piezoelectric ceramic is 5 or less, making the anisotropy of the grain-oriented piezoelectric ceramic in deflective strength small.

Ensuring a grain-oriented piezoelectric ceramic according to this invention having a perovskite structure takes a tetragonal phase as its most stable or metastable grain structure at a temperature in a temperature range of 0°C to 100°C allows the user to enhance the anisotropy of the grains by adjusting the temperature of the ceramic slurry to this temperature and to make the ceramic particles oriented by applying a magnetic field even when the slurry contains a binder.

Furthermore, ensuring the average particle diameter of the ceramic particles in the grain-oriented piezoelectric ceramic according to this invention is in a range of 0.3 $\mu$m to 2.2 $\mu$m provides a sintered multilayer ceramic article that may have a reduced thickness per layer.

A method according to this invention for producing a grain-oriented piezoelectric ceramic makes the grain-oriented piezoelectric ceramic highly oriented, as demonstrated by a degree of orientation of 0.30 or more determined using the Lotgering method, despite the perovskite structure based on a potassium niobate compound containing at least Li and Na.

In a method according to this invention for producing a grain-oriented piezoelectric ceramic, furthermore, adding emulsified acrylic resin as a binder in the step of preparing calcined powder slurry prevents the ceramic particles and the binder from binding together in the calcined powder slurry and therefore prevents the ceramic particles from aggregating, ensuring an oriented sheet-shaped article is obtained even when the magnetic anisotropy of the ceramic particles is small.

Advantageous Effects of Invention

This invention provides a grain-oriented piezoelectric ceramic that is based on a potassium niobate compound containing at least Li and Na and can be produced using a known process for producing piezoelectric ceramics and can be oriented with a high degree of orientation in any intended direction, as well as a method for producing this grain-oriented piezoelectric ceramic.

The foregoing object, other objects, features, and advantages of this invention will become more apparent from the following description of embodiments made with reference to drawings.

Brief Description of Drawings

[Fig. 1] Fig. 1 is a SEM image of a sintered article obtained as sample 1.

[Fig. 2] Fig. 2 presents XRD charts from a predetermined cross-section of sintered grain-oriented piezoelectric ceramic articles obtained as samples 1 to 3 and samples 5 to 7.

Description of Embodiments

The following describes an embodiment of a grain-oriented piezoelectric ceramic according to this invention and a method according to this invention for producing it.

(Grain-oriented piezoelectric ceramic)

A grain-oriented piezoelectric ceramic according to the present invention has a perovskite structure based on a potassium niobate compound that contains at least Li and Na (hereinafter referred to as $(Li, Na, K)NbO_3$). The ceramic particles constituting this grain-oriented piezoelectric ceramic have a spherical or rectangular cubic shape, and their aspect ratio is 5 or less. It is preferred that the average particle diameter of these ceramic particles be in the range of $0.3\ \mu m$ to $2.2\ \mu m$. Making the average particle diameter of the ceramic particles fall within this range ensures a sintered multilayer ceramic article with a reduced thickness per layer is obtained. In an SEM image taken under conditions where the magnification has been adjusted to make the number of ceramic particles of the sintered ceramic article per field of view 30 or more, the particle diameter is based on the ceramic particles seen in the SEM image and determined as the mean of particle diameters in an SEM field of view, with the average particle diameter of a ceramic particle defined as the mean of the length of the particle in the direction where it is the largest in the SEM image (hereinafter absolute maximum length) and the maximum width of the particle in the direction perpendicular to the absolute maximum length (hereinafter diagonal width). The aspect ratio is based on the absolute maximum length divided by the diagonal width of the ceramic particles seen in an SEM image and determined as the mean of this quotient of ceramic particles in an SEM field of view.

A grain-oriented piezoelectric ceramic according to the present invention having a perovskite structure takes a tetragonal phase as its most stable or metastable grain structure at a temperature in a temperature range of 0°C to 100°C.

A grain-oriented piezoelectric ceramic according to the present invention has an axis oriented in the {100} direction. The degree of orientation as determined on a cross-section taken in the {100} direction using the Lotgering method on the basis of an X-ray diffraction (XRD) pattern of a predetermined cross-section of the grain-oriented piezoelectric ceramic is 0.30 or more. The Lotgering method is described in detail hereinafter.

Ensuring the grain structure of the grain-oriented piezoelectric ceramic having a $(Li, Na, K)NbO_3$-based perovskite structure is a tetragonal phase in the present invention offers the following advantages.

In general, a grain-oriented piezoelectric ceramic having a $(Li, Na, K)NbO_3$-based perovskite structure is difficult to make further oriented through the application of a magnetic field because of its small grain-orientational anisotropy in magnetic susceptibility (magnetic anisotropy). It is particularly difficult to make this ceramic further oriented in the presence of a binder because in such a case the binder hinders the rotation of particles the magnetic field drives. Making its grain structure a tetragonal phase enhances the magnetic anisotropy of the grains, allowing the ceramic particles to be oriented upon the application of a magnetic field even when the slurry contains a binder.

A grain-oriented piezoelectric ceramic according to the present invention is therefore a grain-oriented piezo-lectric ceramic that has a $(Li, Na, K)NbO_3$-based perovskite structure and whose degree of orientation as determined using the Lotgering method on the basis of an X-ray diffraction (XRD) pattern of its predetermined cross-section is 0.30 or more.

(Method for producing a grain-oriented piezoelectric ceramic)

The following describes an embodiment of a method according to the present invention for producing a grain-oriented piezoelectric ceramic.

For the production of a grain-oriented piezoelectric ceramic according to the present invention, a ceramic having a perovskite structure based on a potassium niobate compound that contains at least Li and Na (hereinafter referred to as $(Li, Na, K)NbO_3$) is prepared. Elementary raw materials for $(Li, Na, K)NbO_3$, e.g., lithium carbonate, sodium carbonate, potassium carbonate, niobium oxide, lanthanum hydroxide, barium carbonate, zirconium oxide, and manganese oxide, are formulated to a compositional formula $(Li_{0.019}Na_{0.437}K_{0.514}La_{0.05}Ba_{0.05})(Nb_{0.95}Zr_{0.08}Mn_{0.05})O_3$. Mixing and stirring the formulated materials using a ball mill in ethanol as solvent yields elementary raw material-mixed slurry. It is possible to use lithium carbonate, sodium carbonate, potassium carbonate, calcium carbonate, niobium oxide, zirconium oxide, and manganese oxide as elementary raw materials for $(Li, Na, K)NbO_3$ and formulate them to make a composition represented by a compositional formula $(Li_{0.01}Na_{0.442}K_{0.514}Ca_{0.05})(Nb_{0.95}Zr_{0.03}Mn_{0.05})O_3$. It is also possible to use lithium carbonate, sodium carbonate, potassium carbonate, bismuth oxide, niobium oxide, titanium oxide, and manganese oxide and formulate them to make a composition represented by a compositional formula $(Li_{0.01}Na_{0.40}K_{0.50}Bi_{0.09})(Nb_{0.95}Ti_{0.03}Mn_{0.02})O_3$.

The obtained elementary raw material-mixed slurry is dried. Calcining the dried slurry at, for example, 1100°C, yields a calcined article. Dry-milling this calcined article yields a calcined powder. Then mixing this calcined powder with a binder for 24 hours yields calcined powder slurry. The binder is emulsified acrylic resin or acrylic resin dissolved in water, and it is preferred to use emulsified acrylic resin.

The produced calcined powder slurry is applied to a carrier film and dried under a magnetic field. This shapes a green sheet. Applying a magnetic field to the produced calcined powder slurry in this way makes the grain axis of the grains in the green sheet oriented in a predetermined direction (e.g., the {100} direction) in response to the applied magnetic field.

Then pieces of a predetermined size are punched out of the shaped green sheet after an inner electrode has been formed on either primary surface of the green sheet through, for example, the application of Ag paste. Stacking and pressure-bonding these pieces yield a pressure-bonded article. Degreasing the obtained pressure-bonded article and then, for example, firing the degreased article at 1100°C for 3 hours produces the desired grain-oriented piezoelectric ceramic.

The use of emulsified acrylic resin as a binder in a method according to the present invention for producing a grain-oriented piezoelectric ceramic offers the following advantages.

Polyvinyl alcohol, polyvinyl acetate, polyvinyl butyral resin, cellulose resin, and water-soluble acrylic resin, which are binders used in ordinary sheet shaping, adhere in the form of binder molecules to the surface of the ceramic particles constituting the calcined powder in the calcined powder slurry and, furthermore, make multiple ceramic particles bind and aggregate together. When ceramic particles aggregate together, orientational misalignment between the ceramic particles cancels the overall anisotropy of the aggregate and reduces the apparent overall magnetic anisotropy of the aggregate. In the production of a grain-oriented piezoelectric ceramic that has a perovskite structure based on a $(Li, Na, K)NbO_3$ compound, which is of small anisotropy, this prevents the ceramic having a degree of magnetic anisotropy needed for orientation and makes it difficult to obtain a grain-oriented piezoelectric ceramic through the application of a magnetic field. As a solution to this problem, the use of emulsified acrylic resin as a binder prevents the ceramic particles constituting the calcined powder and the binder from binding together in the calcined powder slurry and prevents the ceramic particles from aggregating together, ensuring an oriented sheet-shaped article is obtained even when the magnetic anisotropy of the ceramic particles is small. When a sheet shaped from the ceramic is dried, furthermore, the binder binds the ceramic particles together, yielding a sheet-shaped article with a level of strength that makes the article workable.

Applying a method according to the present invention for producing a grain-oriented piezoelectric ceramic to methods for preparing a grain-oriented ceramic that yield an oriented sheet-shaped article through the shaping of a slurry of a ceramic powder having a $(Li, Na, K)NbO_3$-based perovskite structure into a sheet ensures a highly grain-oriented piezoelectric ceramic is obtained despite through sheet shaping because the grain structure of the ceramic powder is a tetragonal phase. This means that a method according to the present invention for producing a grain-oriented piezoelectric ceramic can be applied to known production methods simply with the addition of a step of applying a magnetic field during sheet shaping, without any change to any other step.

In a method according to the present invention for producing a grain-oriented piezoelectric ceramic, furthermore, the use of emulsified acrylic resin as the binder in the calcined powder slurry would ensure an oriented sheet-shaped article is obtained even when the magnetic anisotropy of the ceramic particles is small, thereby guaranteeing that a workable and oriented shaped article is obtained despite the use of a $(Li, Na, K)NbO_3$ compound, which is of small grain anisotropy and difficult to make oriented using a magnetic field. Moreover, the user can obtain a sheet-shaped article oriented in any desired direction with respect to the sheet face by changing the direction in which the magnetic field is applied. In the production of a multilayer ceramic having an inner electrode, in particular, this allows the user to make the grains oriented in any direction advantageous for the improvement of the electrical characteristics of the device whatever the structure of the inner electrode of the ceramic is.

The following describes illustrative experiments conducted to verify the advantages of grain-oriented piezoelectric ceramics produced using a method according to the present invention for producing a grain-oriented piezoelectric ceramic.

1. Preparation of samples

(Sample 1)

Sample 1 was prepared through the preparation method described below.

Lithium carbonate, sodium carbonate, potassium carbonate, niobium oxide, lanthanum hydroxide, barium carbonate, zirconium oxide, and manganese oxide as elementary raw materials were formulated to make a composition represented by a compositional formula $(Li_{0.019}Na_{0.437}K_{0.514}La_{0.05}Ba_{0.05})(Nb_{0.95}Zr_{0.08}Mn_{0.05})O_3$. The formulated materials were mixed and stirred using a ball mill in ethanol as solvent, yielding elementary raw material-mixed slurry. A dried form of the obtained elementary raw material-mixed slurry was calcined at 1100°C. Dry-milling the obtained calcined article yielded a calcined powder.

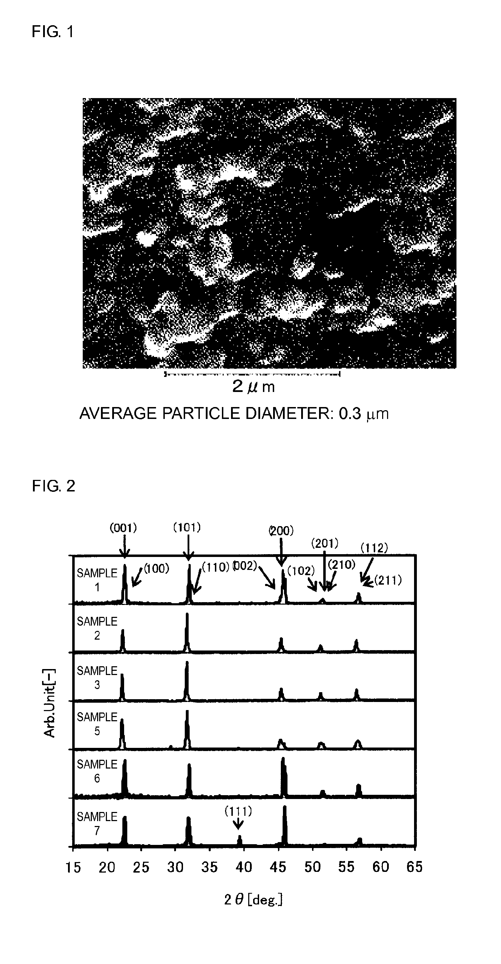

The obtained calcined powder was mixed with 26 wt% emulsified acrylic binder, 2.8 wt% dispersant, and 38 wt% purified water, all based on the weight of the calcined powder, for 24 hours using a ball mill. The obtained slurry was applied to a carrier film and dried under a magnetic field of 9.0 T, yielding a sheet-shaped article in which grains were oriented. The resulting sheet-shaped article was pressure-bonded after the formation of an inner electrode, yielding a pressure-bonded article. Degreasing this pressure-bonded article and firing the degreased article by maintaining it at 1100°C for 3 hours yielded a sintered article (sample 1). Fig. 1 is an SEM image of the sintered article obtained as sample 1. As is demonstrated in Fig. 1, the ceramic particles in the sintered article as sample 1 have a spherical shape.

(Sample 2)

Sample 2 was prepared through the preparation method described below.

Lithium carbonate, sodium carbonate, potassium carbonate, niobium oxide, lanthanum hydroxide, barium carbonate, zirconium oxide, and manganese oxide as elementary raw materials were formulated to make a composition represented by a compositional formula $(Li_{0.019}Na_{0.437}K_{0.514}La_{0.05}Ba_{0.05})$ $(Nb_{0.95}Zr_{0.08}Mn_{0.05})O_3$. The formulated materials were mixed and stirred using a ball mill in ethanol as solvent, yielding elementary raw material-mixed slurry. A dried form of the obtained elementary raw material-mixed slurry was calcined at 1100°C. Dry-milling the obtained calcined article yielded a calcined powder.

The obtained calcined powder was mixed with 26 wt% emulsified acrylic binder, 2.8 wt% dispersant, and 38 wt% purified water, all based on the weight of the calcined powder, for 24 hours using a ball mill. The obtained slurry was applied to a carrier film and dried, yielding a sheet-shaped article. The resulting sheet-shaped article was pressure-bonded after the formation of an inner electrode, yielding a pressure-bonded article. Degreasing this pressure-bonded article and firing the degreased article by maintaining it at 1100°C for 3 hours yielded a sintered article (sample 2).

(Sample 3)

Sample 3 was prepared through the preparation method described below.

Lithium carbonate, sodium carbonate, potassium carbonate, niobium oxide, lanthanum hydroxide, barium carbonate, zirconium oxide, and manganese oxide as elementary raw materials were formulated to make a composition represented by a compositional formula $(Li_{0.019}Na_{0.437}K_{0.514}La_{0.05}Ba_{0.05})$ $(Nb_{0.95}Zr_{0.08}Mn_{0.05})O_3$. The formulated materials were mixed and stirred using a ball mill in ethanol as solvent, yielding elementary raw material-mixed slurry. A dried form of the obtained elementary raw material-mixed slurry was calcined at 1100°C. Dry-milling the obtained calcined article yielded a calcined powder.

The obtained calcined powder was mixed with 26 wt% acrylic binder dissolved in water, 2.8 wt% dispersant, and 38 wt% purified water, all based on the weight of the calcined powder, for 24 hours using a ball mill. The obtained slurry was applied to a carrier film and dried under a magnetic field of 9.0 T, yielding a sheet-shaped article in which grains were oriented. The resulting sheet-shaped article was pressure-bonded after the formation of an inner electrode, yielding a pressure-bonded article. Degreasing this pressure-bonded article and firing the degreased article by maintaining it at 1100°C for 3 hours yielded a sintered article (sample 3).

(Sample 4)

Sample 4 was prepared through the preparation method described below.

Lithium carbonate, sodium carbonate, potassium carbonate, niobium oxide, lanthanum hydroxide, barium carbonate, zirconium oxide, and manganese oxide as elementary raw materials were formulated to make a composition represented by a compositional formula $(Li_{0.019}Na_{0.437}K_{0.514}La_{0.05}Ba_{0.05})$ $(Nb_{0.95}Zr_{0.08}Mn_{0.05})O_3$. The formulated materials were mixed and stirred using a ball mill in ethanol as solvent, yielding elementary raw material-mixed slurry. A dried form of the obtained elementary raw material-mixed slurry was calcined at 1100°C. Dry-milling the obtained calcined article yielded a calcined powder.

The obtained calcined powder was mixed with 2.8 wt% dispersant and 38 wt% purified water for 24 hours using a ball mill. The obtained slurry was applied to a carrier film and dried under a magnetic field of 9.0 T. These conditions, under which the dried slurry was brittle and crumbled, did not yield a sheet-shaped article.

(Sample 5)

Sample 5 was prepared through the preparation method described below.

Sodium carbonate, potassium carbonate, and niobium oxide as elementary raw materials were formulated to a compositional formula $(Na_{0.5}K_{0.5})NbO_3$ and mixed and stirred using a ball mill in ethanol as solvent. A dried form of the obtained slurry was calcined at 1100°C. Dry-milling the obtained calcined article yielded a calcined powder.

The obtained calcined powder was mixed with 26 wt% emulsified acrylic binder, 2.8 wt% dispersant, and 38 wt% purified water, all based on the weight of the calcined powder, for 24 hours using a ball mill. The obtained slurry was applied to a carrier film and dried under a magnetic field of 9.0 T, yielding a sheet-shaped article. The resulting sheet-shaped article was pressure-bonded after the formation of an inner electrode, yielding a pressure-bonded article. Degreasing this pressure-bonded article and firing the degreased article by maintaining it at 1100°C for 3 hours yielded a sintered article (sample 5).

(Sample 6)

Sample 6 was prepared through the preparation method described below.

Lithium carbonate, sodium carbonate, potassium carbonate, calcium carbonate, niobium oxide, zirconium oxide, and manganese oxide as elementary raw materials were formulated to make a composition represented by a compositional formula $(Li_{0.01}Na_{0.442}K_{0.514}Ca_{0.05})(Nb_{0.95}Zr_{0.03}Mn_{0.05})O_3$. The formulated materials were mixed and stirred using a ball mill in ethanol as solvent, yielding elementary raw material-mixed slurry. A dried form of the obtained elementary raw material-mixed slurry was calcined at 1100°C. Dry-milling the obtained calcined article yielded a calcined powder.

The obtained calcined powder was mixed with 26 wt% emulsified acrylic binder, 2.8 wt% dispersant, and 38 wt% purified water, all based on the weight of the calcined powder, for 24 hours using a ball mill. The obtained slurry was applied to a carrier film and dried under a magnetic field of 9.0 T, yielding a sheet-shaped article in which grains were oriented. The resulting sheet-shaped article was pressure-bonded after the formation of an inner electrode, yielding a pressure-bonded article. Degreasing this pressure-bonded article and firing the degreased article by maintaining it at 1100°C for 3 hours yielded a sintered article (sample 6).

(Sample 7)

Sample 7 was prepared through the preparation method described below.

Lithium carbonate, sodium carbonate, potassium carbonate, bismuth oxide, niobium oxide, titanium oxide, and manganese oxide as elementary raw materials were formulated to make a composition represented by a compositional formula $(Li_{0.01}Na_{0.40}K_{0.50}Bi_{0.09})(Nb_{0.95}Ti_{0.03}Mn_{0.02})O_3$. The formulated materials were mixed and stirred using a ball mill in ethanol as solvent, yielding elementary raw material-mixed slurry. A dried form of the obtained elementary raw material-mixed slurry was calcined at 1100°C. Dry-milling the obtained calcined article yielded a calcined powder.

The obtained calcined powder was mixed with 26 wt% emulsified acrylic binder, 2.8 wt% dispersant, and 38 wt% purified water, all based on the weight of the calcined powder, for 24 hours using a ball mill. The obtained slurry was applied to a carrier film and dried under a magnetic field of 9.0 T, yielding a sheet-shaped article in which grains were oriented. The resulting sheet-shaped article was pressure-bonded after the formation of an inner electrode, yielding a pressure-bonded article. Degreasing this pressure-bonded article and firing the degreased article by maintaining it at 1100°C for 3 hours yielded a sintered article (sample 7). The ceramic particles in the sintered article as sample 7 have a rectangular cubic shape.

2. Evaluation

The degree of orientation of the sintered articles obtained as samples through the above preparation method was calculated using mathematical formula (1) below in accordance with the Lotgering method. In the calculations of the degree of orientation, a sintered article having a compositional formula of $(Li_{0.019}Na_{0.437}K_{0.514}La_{0.05}Ba_{0.05})(Nb_{0.95}Zr_{0.08}Mn_{0.05})O_3$, obtained through the firing of an article shaped with no magnetic field applied, was used as a reference sample.

[Math. 1]

$$\text{Degree of orientation } F = \frac{\dfrac{\Sigma\, I(HKL)}{\Sigma\, I(hkl)} - \dfrac{\Sigma\, I_0(HKL)}{\Sigma\, I_0(hkl)}}{1 - \dfrac{\Sigma\, I_0(HKL)}{\Sigma\, I_0(hkl)}} \times 100 \qquad (1)$$

$\Sigma I(HKL)$ denotes the sum of the intensity of X-ray peaks in a particular grain face (HKL) of the sintered article of interest, and $\Sigma I(hkl)$ denotes the sum of the intensity of X-ray peaks in all grain faces (hkl) of the sintered article of interest. $\Sigma I_0(HKL)$ is the sum of the intensity of X-ray peaks in a particular grain face (HKL) of the reference sample, and

$\Sigma I_0(hkl)$ is the sum of the intensity of X-ray peaks in all grain faces (hkl) of the reference sample.

The degree of orientation was based on indexable peaks observed within the range where $2\theta = 15°$ to $65°$ in the XRD chart. Fig. 2 presents XRD charts from a {100} cross-section of the sintered grain-oriented piezoelectric ceramic articles obtained as samples 1 to 3 and samples 5 to 7. Table 1 summarizes the results of evaluations of samples 1 to 3 and samples 5 to 7. The table does not include sample 4, which was unevaluable because the aforementioned failure to obtain a sheet-shaped article made it impossible to obtain a sintered grain-oriented piezoelectric ceramic article.

[Table 1]

| Sintered article | Composition | Binder | Magnetic field applied while shaping | Degree of orientation according to the Lotgering method |
|---|---|---|---|---|
| Sample 1 | $(Li_{0.019}Na_{0.437}K_{0.514}La_{0.05}Ba_{0.05})(Nb_{0.95}Zr_{0.08}Mn_{0.05})O_3$ | Emulsified acrylic resin | Yes | 0.30 |
| Sample 2* | $(Li_{0.019}Na_{0.437}K_{0.514}La_{0.05}Ba_{0.05})(Nb_{0.95}Zr_{0.08}Mn_{0.05})O_3$ | Emulsified acrylic resin | No | 0.00 |
| Sample 3* | $(Li_{0.019}Na_{0.437}K_{0.514}La_{0.05}Ba_{0.05})(Nb_{0.95}Zr_{0.08}Mn_{0.05})O_3$ | Acrylic resin dissolved in water | Yes | 0.03 |
| Sample 5* | $(Na_{0.5}K_{0.5})NbO_3$ | Emulsified acrylic resin | Yes | 0.07 |
| Sample 6 | $(Li_{0.01}Na_{0.442}K_{0.514}Ca_{0.05})(Nb_{0.95}Zr_{0.03}Mn_{0.05})O_3$ | Emulsified acrylic resin | Yes | 0.49 |
| Sample 7 | $(Li_{0.01}Na_{0.40}K_{0.50}Bi_{0.09})(Nb_{0.95}Ti_{0.03}Mn_{0.02})O_3$ | Emulsified acrylic resin | Yes | 0.46 |

The symbol * in the table means that the sample is out of the scope of the present invention.

Furthermore, the average particle diameter and aspect ratio of ceramic particles in each of the sintered articles obtained as samples 1 and 7 were measured. The average particle diameter was based on the ceramic particles seen in an SEM image of the sintered ceramic article and determined as the mean of particle diameters in an SEM field of view, with the particle diameter of a ceramic particle defined as the mean of its absolute maximum length and diagonal width. The aspect ratio was based on the absolute maximum length divided by the diagonal width of the ceramic particles seen in an SEM image and determined as the mean of this quotient of ceramic particles in an SEM field of view. Table 2 summarizes the average particle diameter and aspect ratio of ceramic particles in each of the sintered articles obtained as samples 1 and 7.

[Table 2]

| Sintered article | Average particle diameter ($\mu$m) | Aspect ratio |
|---|---|---|
| Sample 1 | 0.3 | 1.3 |
| Sample 7 | 2.2 | 1.8 |

Samples 1, 6, and 7 in Table 1 indicate that the application of a magnetic field and the use of emulsified acrylic resin as a binder resulted in a degree of orientation of 0.30 or more, with regard to the degree of orientation as calculated using the Lotgering method on a {100} cross-section. This suggests that the tetragonal grain structure of these grain-oriented piezoelectric ceramics having a (Li, Na, K)$NbO_3$-based perovskite structure and the use of emulsified acrylic resin as a binder made it possible to make the ceramic particles oriented despite the small magnetic anisotropy of the (Li, Na, K)$NbO_3$ compound.

Sample 5, made from a slurry that does not take a tetragonal phase at any temperature within the temperature range of 0°C to 100°C and therefore in which the magnetic anisotropy of ceramic particles cannot be increased, had a small degree of orientation as calculated using the Lotgering method on a {100} cross-section. Although the slurry takes a tetragonal phase at a temperature within the temperature range of 200°C to 400°C, it cannot exist as aqueous slurry at this temperature because of the evaporation of water.

According to Table 2, furthermore, samples 1 and 7 have an aspect ratio of 5 or less and an average particle diameter of 0.3 $\mu$m to 2.2 $\mu$m. This allows a sintered multilayer ceramic article to be obtained with a reduced thickness per layer.

**Claims**

1. A grain-oriented piezoelectric ceramic comprising a perovskite structure based on a potassium niobate compound containing at least Li and Na, wherein
an aspect ratio of ceramic particles constituting the grain-oriented piezoelectric ceramic is 5 or less, the grain-oriented piezoelectric ceramic has an axis oriented in a {100} direction of the perovskite structure, and a degree of orientation as determined using the Lotgering method on the basis of an X-ray diffraction pattern of a cross-section taken in the direction is 0.30 or more.

2. The grain-oriented piezoelectric ceramic according to Claim 1, wherein the grain-oriented piezoelectric ceramic having a perovskite structure takes a tetragonal phase as a most stable or metastable grain structure thereof at a temperature in a temperature range of 0°C to 100°C.

3. The grain-oriented piezoelectric ceramic according to Claim 1 or 2, wherein an average particle diameter of the ceramic particles is in a range of 0.3 $\mu$m to 2.2 $\mu$m.

4. A method for producing a grain-oriented piezoelectric ceramic, the grain-oriented piezoelectric ceramic being a perovskite-structured grain-oriented piezoelectric ceramic whose degree of orientation as determined using the Lotgering method on the basis of an X-ray diffraction pattern of a predetermined cross-section thereof is 0.30 or more, the method comprising:

   a step of preparing elementary raw material-mixed slurry containing an elementary raw material that is a perovskite compound based on a potassium niobate compound that contains at least Li and Na;
   a step of calcining a dried form of the elementary raw material-mixed slurry to prepare a calcined powder that takes a tetragonal phase as a most stable or metastable grain structure thereof at a temperature in a temperature range of 0°C to 100°C;
   a step of preparing calcined powder slurry containing the calcined powder;
   a step of shaping the calcined powder slurry into a sheet; and
   a step of applying a magnetic field to the sheet shaped from the calcined powder slurry.

5. The grain-oriented piezoelectric ceramic according to Claim 4, wherein the step of preparing calcined powder slurry includes
adding emulsified acrylic resin as a binder.

FIG. 1

2 μm

AVERAGE PARTICLE DIAMETER: 0.3 μm

FIG. 2

## INTERNATIONAL SEARCH REPORT

| International application No. |
| --- |
| PCT/JP2014/052623 |

A. CLASSIFICATION OF SUBJECT MATTER
*C04B35/00*(2006.01)i, *C04B35/622*(2006.01)i, *H01L41/187*(2006.01)i, *H01L41/22*(2013.01)i

According to International Patent Classification (IPC) or to both national classification and IPC

B. FIELDS SEARCHED

Minimum documentation searched (classification system followed by classification symbols)
C04B35/00-35/22, C04B35/622

Documentation searched other than minimum documentation to the extent that such documents are included in the fields searched
Jitsuyo Shinan Koho          1922-1996   Jitsuyo Shinan Toroku Koho   1996-2014
Kokai Jitsuyo Shinan Koho     1971-2014   Toroku Jitsuyo Shinan Koho   1994-2014

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X<br>Y<br>A | JP 2009-46376 A  (NGK Insulators, Ltd.),<br>05 March 2009 (05.03.2009),<br>paragraphs [0015], [0032] to [0035]; table 1;<br>fig. 3<br>& JP 2009-40672 A        & US 2008/0248277 A1<br>& US 2008/0206561 A1    & EP 1972604 A1<br>& EP 1972606 A1          & EP 1975137 A1<br>& EP 2128111 A1          & EP 2138472 A2<br>& EP 2351720 A2          & WO 2008/105290 A1 | 1<br>2,4<br>3,5 |
| Y<br>A | JP 2005-228865 A  (Toyota Central Research and<br>Development Laboratories, Inc.),<br>25 August 2005 (25.08.2005),<br>claim 4; paragraphs [0155], [0161], [0198];<br>table 18<br>(Family: none) | 2,4<br>3,5 |

| ☒ | Further documents are listed in the continuation of Box C. | ☐ | See patent family annex. |
| --- | --- | --- | --- |

\* Special categories of cited documents:
"A"  document defining the general state of the art which is not considered  to be of particular relevance
"E"  earlier application or patent but published on or after the international filing date
"L"  document which may throw doubts on priority claim(s) or which is cited to establish the publication date of another citation or other special reason (as specified)
"O"  document referring to an oral disclosure, use, exhibition or other means
"P"  document published prior to the international filing date but later than the priority date claimed

"T"  later document published after the international filing date or priority date and not in conflict with the application but cited to understand the principle or theory underlying the invention
"X"  document of particular relevance; the claimed invention cannot be considered novel or cannot be considered to involve an inventive step when the document is taken alone
"Y"  document of particular relevance; the claimed invention cannot be considered to involve an inventive step when the document is combined with one or more other such documents, such combination being obvious to a person skilled in the art
"&"  document member of the same patent family

| Date of the actual completion of the international search<br>     28 February, 2014 (28.02.14) | Date of mailing of the international search report<br>     18 March, 2014 (18.03.14) |
| --- | --- |
| Name and mailing address of the ISA/<br>   Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2014/052623

C (Continuation).   DOCUMENTS CONSIDERED TO BE RELEVANT

| Category* | Citation of document, with indication, where appropriate, of the relevant passages | Relevant to claim No. |
|---|---|---|
| Y<br>A | JP 2007-281439 A  (NGK Insulators, Ltd.),<br>25 October 2007 (25.10.2007),<br>claims 4, 8<br>& US 2007/0216260 A1    & EP 1835554 A2<br>& CN 101038950 A | 2,4<br>3,5 |
| Y<br>A | WO 2008/029574 A1  (Konica Minolta Holdings,<br>Inc.),<br>13 March 2008 (13.03.2008),<br>claim 1; paragraphs [0109], [0110]<br>& US 2009/0201345 A1    & EP 2060548 A1<br>& AT 545619 T | 2,4<br>3,5 |
| Y<br>A | JP 2010-269983 A  (TDK Corp.),<br>02 December 2010 (02.12.2010),<br>claim 3; paragraph [0023]; table 1<br>& US 2012/0019108 A1    & WO 2010/134604 A1 | 2,4<br>3,5 |
| Y<br>A | JP 2011-251866 A  (NGK Insulators, Ltd.),<br>15 December 2011 (15.12.2011),<br>claims 1 to 3; paragraphs [0038], [0039],<br>[0044]<br>(Family: none) | 4<br>5 |
| Y<br>A | JP 2008-208004 A  (Nagaoka University of<br>Technology),<br>11 September 2008 (11.09.2008),<br>claim 1<br>(Family: none) | 4<br>5 |
| A | JP 2011-179056 A  (Taiheiyo Cement Corp.),<br>15 September 2011 (15.09.2011),<br>paragraph [0037]<br>(Family: none) | 5 |
| A | JP 2010-52977 A  (Kyocera Corp.),<br>11 March 2010 (11.03.2010),<br>paragraphs [0030], [0031], [0034]<br>(Family: none) | 2,4 |
| A | JP 2010-225705 A  (Nippon Soken, Inc.),<br>07 October 2010 (07.10.2010),<br>paragraphs [0038] to [0040]<br>(Family: none) | 2,4 |
| P,X | JP 2013-95627 A  (Taiyo Yuden Co., Ltd.),<br>20 May 2013 (20.05.2013),<br>claim 7; paragraphs [0002], [0013], [0014],<br>[0016], [0038], [0047] to [0067]<br>(Family: none) | 1 |

Form PCT/ISA/210 (continuation of second sheet) (July 2009)

**INTERNATIONAL SEARCH REPORT**

International application No.

PCT/JP2014/052623

C (Continuation).  DOCUMENTS CONSIDERED TO BE RELEVANT

| Category* | Citation of document, with indication, where appropriate, of the relevant passages | Relevant to claim No. |
|---|---|---|
| P,A | JP 2014-12620 A (Murata Mfg. Co., Ltd.), 23 January 2014 (23.01.2014), claims 1, 4 (Family: none) | 5 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003012373 A